(19) Europäisches Patentamt
European Patent Office
Office européen des brevets

(11) **EP 3 731 535 A1**

(12) **EUROPEAN PATENT APPLICATION**

(43) Date of publication:
**28.10.2020 Bulletin 2020/44**

(21) Application number: **19175499.3**

(22) Date of filing: **20.05.2019**

(51) Int Cl.:
**H04Q 9/00** *(2006.01)*

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **22.04.2019 US 201916390919**

(71) Applicant: **Navitas Solutions, Inc.**
**Hillsborough, NJ 08844 (US)**

(72) Inventors:
- LEE, Jaesik
  Basking Ridge, NJ New Jersey 07920 (US)
- LEE, Inseop
  Pittstown, NJ New Jersey 08867 (US)
- LEE, Minkyu
  Ringoes, NJ New Jersey 08551 (US)
- CHON, Andrew M.
  Princeton, NJ New Jersey 08540 (US)

(74) Representative: **Dendorfer, Claus et al**
**Dendorfer & Herrmann**
**Patentanwälte Partnerschaft mbB**
**Neuhauser Straße 47**
**80331 München (DE)**

(54) **HYBRID THREE-TIER BATTERY MANAGEMENT SYSTEM FOR FAST DATA ACQUISITION TIME**

(57) Battery management system (BMS) for collecting data concerning battery cells in a battery pack includes a plurality of sensor nodes, each configured to be connected to at least one corresponding battery cell of a battery pack. The BMS also includes one or more master nodes configured to communicate with the sensor nodes in a at least a first communication session to receive battery cell data from the sensor nodes. The BMS also includes at least one top level node configured to communicate with the one or more master nodes in at least a second communication session. In this second communication session, the top level node receives the battery cell data from the one or more master nodes. To facilitate improved data acquisition times, the one or more master nodes are each configured to conduct the first communication session concurrent with the second communications session.

EP 3 731 535 A1

FIG. 3

# Description

## BACKGROUND

### Statement of the Technical Field

The technical field of this disclosure concerns battery management systems, and more particularly concerns methods and systems which facilitate management of large scale battery systems.

### Description of the Related Art

Lithium-ion (Li-ion) batteries are growing in popularity as energy storage reservoirs for industrial and automotive applications, high-voltage energy uses (smart grid), such as wind turbines, photo-voltaic cells, and hybrid electric vehicles. This growing popularity has spurred demand for safer, higher performing battery monitoring and protection systems. Battery stacks using Li-Ion technology can comprise a large number of individual cells totaling hundreds of cells at different voltages. Each cell must be properly monitored and balanced to ensure user safety, improve battery performance and extend battery life. Therefore, the battery management system (BMS) is one of critical components for small and large-scaled battery applications.

The BMS monitors the voltage, the current, impedance, and the temperature of each cell. Since a BMS has to monitor each and every Li-Ion battery cell, it had been a common practice to wire the BMS to every Li-Ion cell. When the number of Li-Ion cells increases to a few hundred, or up to thousands, which is often the case for electric vehicle (EV) or power plant applications, the wire harness becomes a serious problem. Thus, one of the issues of BMS implementation is wiring. To avoid such problem, conventional systems have used wireless transceivers to facilitate communications between a sensor level node mounted on each battery cell that is wirelessly connected to master-level battery management unit.

The automobile industry is a key market with respect to battery management systems. Within this market, safety considerations and the need to protect expensive battery cells are causing manufacturers to demand faster data update times with respect to the state of charge (SOC) of each battery cell. For example, rather than being satisfied with updates every 50 milliseconds, as was acceptable in older systems, manufacturers are beginning to demand data updates on each battery cell at least every 10 milliseconds. The technical challenge with older two-layer BMS network hierarchies is that a master-level node cannot cycle through communications with all of the sensor-level nodes, and report same, at a rate that is high enough to satisfy the faster data update time requirement specification. There are simply too many batteries.

## SUMMARY

This document concerns a battery management system for collecting data concerning battery cells in a battery pack, where the battery pack comprises a multiplicity of battery cells. The battery management system (BMS) includes a plurality of sensor nodes (S-BMU). Each of the sensor nodes is configured to be connected to at least one corresponding battery cell of a battery pack. Each sensor node will include at least one sensor which is configured to facilitate measurement of a battery cell characteristic. The BMS also includes one or more master nodes (M-BMU), each configured to communicate with the plurality of sensor nodes. The master nodes communicate with the sensor nodes in a at least a first communication session which involves requesting from the plurality of sensor nodes battery cell data representative of the battery cell characteristics. During such session, the master node will also receive the battery cell data from the plurality of sensor nodes. The BMS also includes at least one top level node (T-BMU). The top level node is configured to communicate with the one or more master nodes in at least a second communication session. In this second communication session, the top level node receives the battery cell data from the one or more master nodes. To facilitate improved data acquisition times, the one or more master nodes are each configured to conduct the first communication session concurrent with the second communications session.

To facilitate these concurrent communications, the master nodes will comprise a first data transceiver configured to facilitate the first communication sessions with the plurality of sensor nodes, and a second data transceiver different from the first data transceiver, that is configured to concurrently facilitate the second communication sessions. According to one aspect, the first data transceiver is a wireless transceiver. The second data transceiver can be either a wired transceiver and a wireless transceiver. In some scenarios, the at least one master node and the top level node share a common electrical ground, and under these conditions the second data transceiver is advantageously selected to be a wired transceiver.

Each of the sensor nodes can be configured to redundantly communicate the battery cell data. For example, this can involve resending identical battery cell data respectively to a plurality of the master nodes during a plurality of predetermined time periods. According to one aspect of the solution, a timing offset can be assigned to one or more of the sensor nodes. The timing offset can be selected so as to cause the first communication session of each said sensor node with a particular one of the master nodes to be offset in time relative to the first communications sessions of others of the sensor nodes with the particular master node. As such, the timing offset can be selected to have a duration that is equal to at least one of the predetermined time period or time slot, and an integer multiple of the predetermined time period or time slot.

In some scenarios, more than one of the master nodes can be configured receive the battery cell data from each of the sensor nodes contained in the battery pack during a battery management session. In such instances, each of the plurality of master nodes can be configured to communicate the battery cell data received from each of the sensor nodes in the battery pack to the at least one top level node. Consequently, the top level node receives redundant battery cell data from the plurality of master nodes.

The master nodes can be configured to determine at least one of a state-of-charge (SoC) and a state-of-health (SoH) of the battery cells associated with each of the sensor nodes from which it receives battery cell data. Each of the master nodes in such a scenario then can be further configured to communicate the battery cell data, the SoC and/or SoH to the at least one top level node. In other scenarios, each of the sensor nodes is configured to determine the SoC and SoH of a battery cell to which it is connected. Such SoC and SoH data can then be communicated to a master node, and ultimately to a top level node.

According to one aspect, the top level node is advantageously configured to use the battery cell data received from at least one of the master nodes to calculate one or both of the SoC and the SoH of each battery cell. Note that this can be a redundant calculation in those scenarios where the SoC or SoH has already been calculated in a sensor cell or a master cell. In such a scenario, the top level node can be advantageously configured to compare at least one of the SoC and the SoH that has been calculated at the top level node, to at least one of an SoC or SoH calculated in a master node or a sensor level node for a corresponding battery cell. This process, whereby a comparison of SoC or SoH values calculated for a particular battery cell at two different nodes, can facilitate system reliability by providing a means to verify the accuracy of the SoC and/or SoH at the top level node.

The solution can also involve a method of acquiring battery cell data from a multiplicity of battery cells in a battery pack. Such a method can involve using a plurality of sensor nodes, which are respectively connected to a plurality of battery cells of the battery pack to periodically determine battery cell data for each battery cell. Thereafter, a first communication session can be established between each sensor node and each of one or more master nodes to receive in each of the one or more master nodes the battery cell data for each of the plurality of battery cells. Further, a second communication session can be established between at least one top level node and each of the one or more master nodes to obtain the battery cell data for each battery cell which has been received by the one or more master nodes. Advantageously, a data acquisition time for the battery pack can be minimized by configuring each of the one or more master nodes to perform the second communication sessions concurrent with the first communication sessions.

In the foregoing method, a first data transceiver of each master node can be used to facilitate each of the first communication sessions, and a second data transceiver of each master node can be used to concurrently facilitate each of the second communication sessions. A wireless communication mode is advantageously used to facilitate each of the first communication sessions. A communication mode for the second communication sessions can be either a wired or a wireless communication mode. However, where the one or more master nodes and the top level node share a common electrical ground, a wired communication mode is advantageously used to facilitate each of the second communication sessions.

The method can further involve redundantly communicating identical battery cell data from each of the plurality of sensor nodes, to each of a plurality of master nodes during a plurality of predetermined time periods. In some scenarios this can involve applying a timing offset to one or more of the sensor nodes to cause the first communication session of each said sensor node with a particular one of the master nodes during the predetermined time period to be offset in time relative to corresponding first communications sessions of others of the sensor nodes with the particular master node.

**BRIEF DESCRIPTION OF THE DRAWINGS**

This disclosure is facilitated by reference to the following drawing figures, in which like numerals represent like items throughout the figures, and in which:

FIG. 1 is drawing which is useful for understanding a conventional wireless battery area network (WiBaAN).

FIG. 2 is a timing diagram which is useful for understanding certain limitations of a data acquisition process in a conventional WiBaAN shown in FIG. 1.

FIG. 3 is a drawing which is useful for understanding one aspect of a WiBaAN which facilitates fast data acquisition time.

FIG. 4 is a drawing that is useful for understanding an alternative configuration of a WiBaAN which facilitates fast data acquisition time.

FIG. 5 is a timing diagram which is useful for understanding certain advantages associated with the WiBaAN shown in FIGs. 3 and 4.

FIG. 6 is a drawing which is useful for understanding a generalized network configuration for a WiBaAN to facilitate faster data acquisition time.

FIG. 7 is a simplified example of a WiBaAN network which is useful for understanding certain advantages associated with the WiBaAN network configuration shown in FIG. 6.

FIG. 8 is a timing diagram which is useful for understanding an exemplary data reporting cycle for the WiBaAN in FIG. 7.

FIG. 9 is a timing diagram which is useful for understanding an improved data communication protocol in which timing offsets are used to facilitate faster data acquisition time.

## DETAILED DESCRIPTION

It will be readily understood that the solution described herein and illustrated in the appended figures could involve a wide variety of different configurations. Thus, the following more detailed description, as represented in the figures, is not intended to limit the scope of the present disclosure, but is merely representative of certain implementations in various different scenarios. While the various aspects are presented in the drawings, the drawings are not necessarily drawn to scale unless specifically indicated.

One step toward satisfying the faster update times needed in a BMS can involve the utilization of a three-level or three-tier hierarchical network structure as disclosed in U.S. Patent No. US 9,293,935, the disclosure of which is incorporated herein by reference. Within such hierarchical network systems there are sensor-level nodes which acquire battery data directly from the battery cells, master-level nodes which receive and collect data from the sensor-level nodes, and top-level nodes which collect data from the master-level nodes and report same to a monitoring system, such as a system computer. The three-layer hierarchy divides the communication load with sensor-level nodes among many master-level nodes, and then consolidates this information in the top-level node. The various nodes within the hierarchical network can communicate using wireless or wired communications protocols.

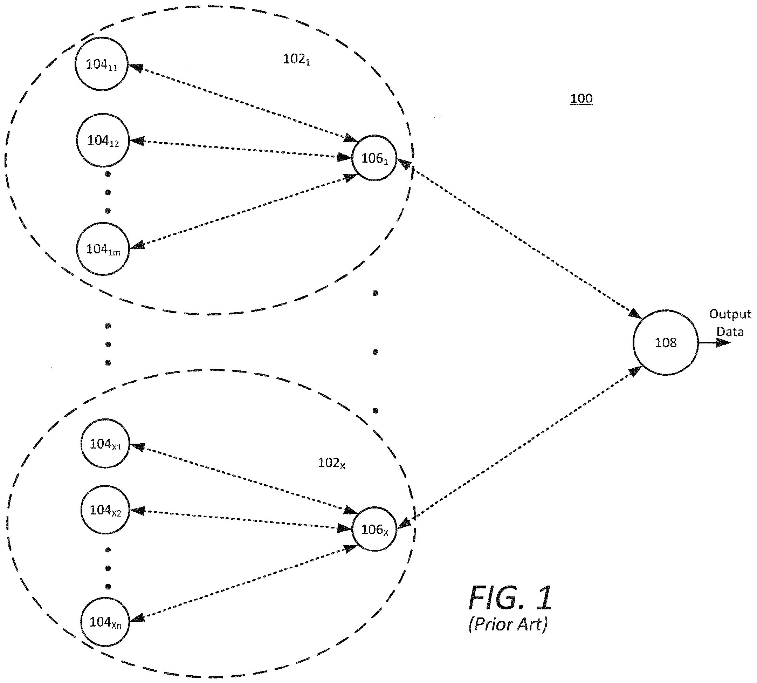

An example of a hierarchical star network topology used in a conventional wireless battery area network (WiBaAN) is shown in FIG. 1. The WiBaAN 100 contains three-levels or tiers of nodes. The nodes include a plurality of sensor (or slave) battery management units (S-BMU) $104_{11}$, $104_{12}$, ... $104_{1m}$, ...$104_{x1}$, 104x2, ... $104_{xn}$. (hereinafter $104_{11}$..$104_{xn}$) The nodes also include a plurality of master nodes or M-BMUs identified in FIG. 1 as $106_1$, ... $106_x$. Finally, the WiBaAN includes a top-level nodes or T-BMU 108. The S-BMU $104_{11}$..$104_{xn}$ are arranged to measure certain characteristics of each battery cell within a group of battery cells. For example, the group can include an entire battery pack of a particular electric vehicle (EV) or energy storage system (ESS). A wireless battery module network $102_1$, ... $102_x$ (herein-

after $102_1$..$102_x$) consists of a plurality of the S-BMUs (e.g., $104_{11}$..$104_{1m}$) and a single M-BMU (e.g., $106_1$). Together these nodes provide sensing and data acquisition for a particular battery module which is understood to include a predetermined number of the battery cells. As a result, one WiBaAN can consist of one or more of the wireless battery module networks $102_1$, ... $102_x$.

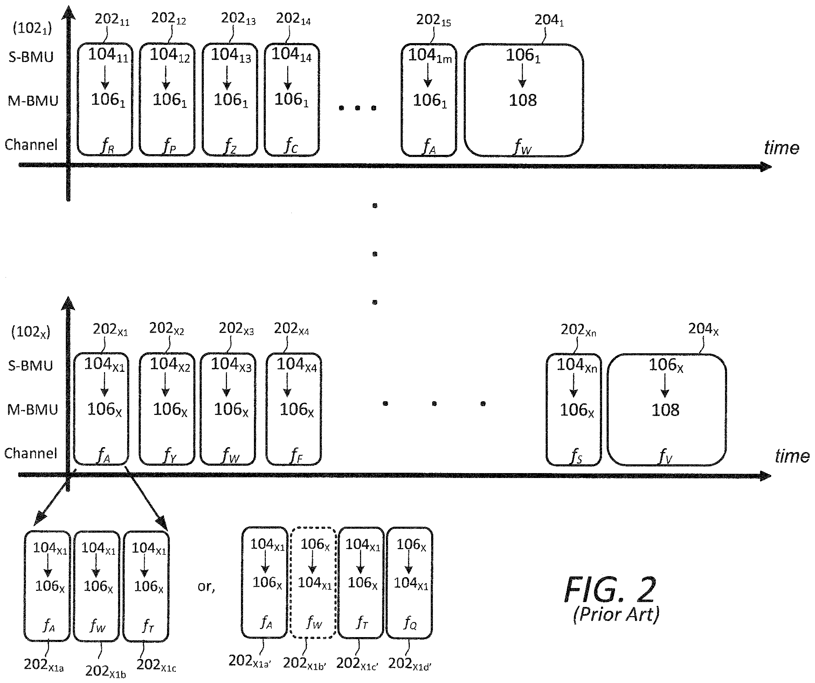

FIG. 2 shows a timing diagram for wireless battery module networks $102_1$..$102_x$ in FIG. 1. In a wireless battery module network, each S-BMU wirelessly communicates with an M-BMU at a pre-determined time slot on a different frequency channel $f_A$, $f_B$, $f_C$, ... $f_Z$. The arrows in each time slot indicate that battery cell data is being communicated from the identified S-BMU to the identified M-BMU. For example, in a first wireless battery module $102_1$, battery cell data is transmitted on frequency $f_R$ in time slot $202_{11}$ from S-BMU $104_{11}$ to M-BMU $106_1$. Thereafter, battery data is communicated in time slot $202_{12}$ from S-BMU $104_{12}$ to M-BMU $106_1$, on frequency $f_P$. The process continues in this way until all S-BMU in a particular battery module network $102_1$ has reported its data to the M-BMU. Similarly, in a battery module network $102_x$, each S-BMU $104_{x1}$..$102_{xn}$ reports to an M-BMU $106_x$ during a time slot $202_{x1}$, $202_{x2}$, ... $202_{xn}$.

Notably, each S-BMU can be configured to repeatedly transmit the same data several times during a particular time slot in order to increase communication reliability. This is illustrated in FIG. 2 with respect to time slot $202_{x1}$ associated with battery module network $102_x$. Here it is shown that an S-BMU $104_{x1}$ can transmit the same data three times (e.g., in sub-time slots $202_{x1a}$, $202_{x1b}$, $202_{x1c}$) respectively on frequency $f_A$, $f_W$, and $f_T$. In such a scenario, an S-BMU $104_{x1}$ can send data to an M-BMU 106X in a first sub-time slot $202_{x1a}$. In time slot $202_{x1b}$, the S-BMU $104_{x1}$ can send the same data to the M-BMU $106_x$ again, regardless of whether the M-BMU received the data on the first transmission. Thereafter, in sub-time slot $202_{x1c}$ the same data can be sent a third time, to the same M-BMU regardless of whether the M-BMU received the data in the first or second transmission. Alternatively, the S-BMU can selectively retransmit the data to the M-BMU only in those instances where the initial transmission is not received. This is shown with respect to the alternative set of sub-time slots $202_{x1a'}$-$202_{x1d'}$. Here, the S-BMU $104_{x1}$ sends the data during a first sub-time slot $202_{x1a'}$ and then waits to see if the M-BMU 106X sends an acknowledgment (ACK) signal in $202_{x1b'}$. If not, then the S-BMU will repeat the transmission in $202_{x1c'}$ and wait to receive an ACK from the M-BMU in $202_{x1d'}$.

Each wireless battery module network $102_1$..$102_x$ operates concurrently with other battery module networks $102_1$..$102_x$. An S-BMU reporting cycle includes reporting to a corresponding M-BMU by all of the S-BMU in a particular wireless battery module network $102_1$..$102_x$. FIG. 2 shows that at the end of each reporting cycle, a long time slot $204_1$,...$204_x$ is necessary to accommodate the data transfer between each M-BMU

$106_1..106_X$ and a T-BMU 108. In a wireless system that repeatedly transmits the same data several times in order to increase communication reliability, the total data acquisition time ($T_{DAT}$) of the WiBaAN comprised of a total of X battery module networks is denoted by:

$$T_{DAT} = n * r * X * T + t(MT)$$

where

> $n$ = the total number of S-BMUs in a battery module network,
> $r$ = the number of repeated data transmission between a S-BMU and a M-BMU,
> $X$ = the number of M-BMUs in a particular WiBaAN,
> $T$ = unit data packet length (unit time slot length), and
> $t(MT)$ = a data packet length between a M-BMU and a T-BMU.

From the foregoing it may be understood that a three-tier battery management system has certain advantages for improving the rate at which data is acquired with respect to each battery cell in a battery pack. But the use of three-tier battery management systems by itself can in some scenarios be insufficient to facilitate the faster update times that are needed for monitoring each cell in a battery pack comprising hundreds or thousands of cells. The need for redundant transmissions to prevent data loss in a noisy communications environment, and inefficient use of sensor-level node communications capabilities can limit data throughput. Consequently, the desired rate at which updates can be provided with respect to each battery cell may not be achieved.

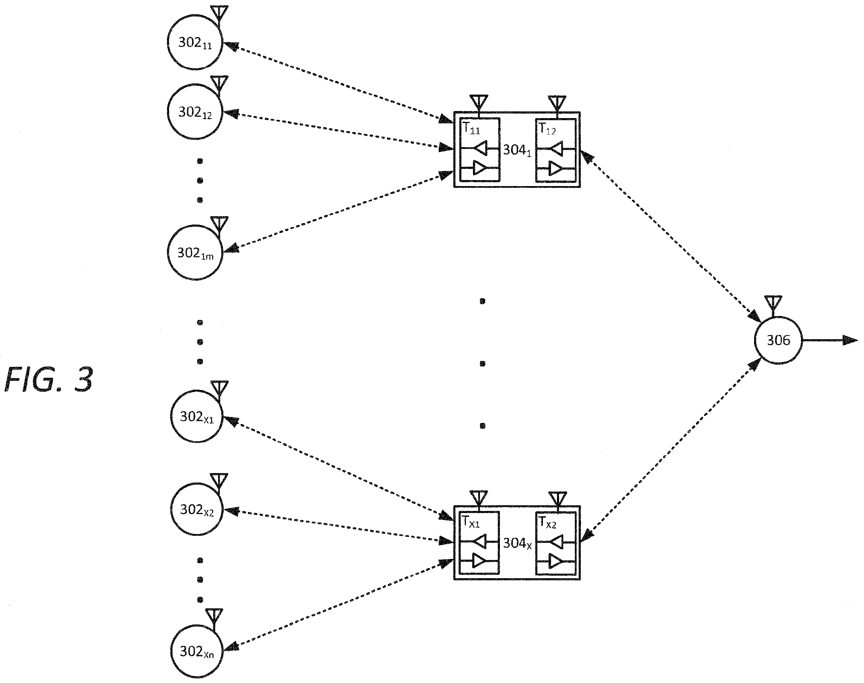

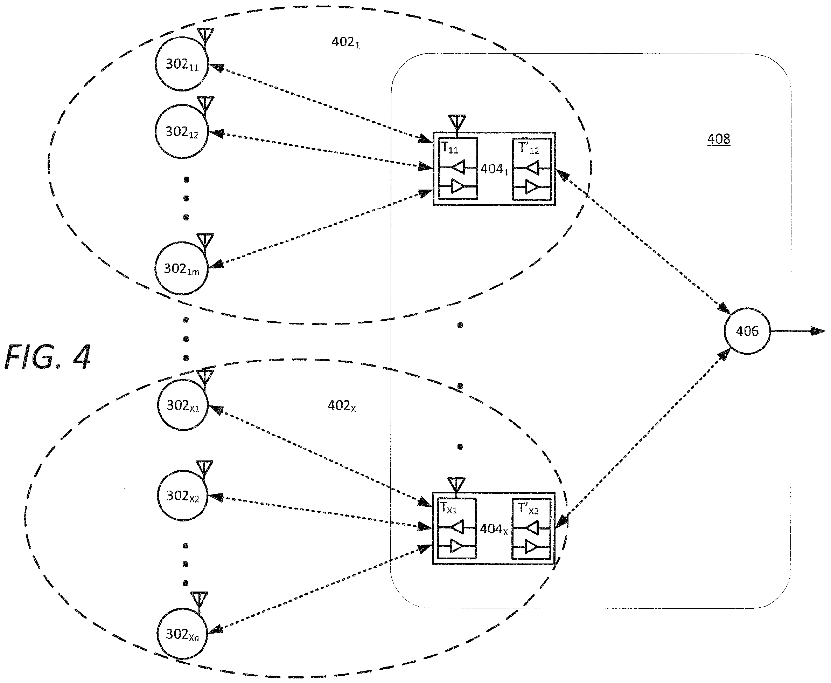

The solution involves a battery management system in which master-level nodes have dual data transceivers to facilitate concurrent communications with sensor-level nodes and top-level nodes. This arrangement, when combined with other techniques described herein, that facilitate more efficient use of the sensor-level nodes, can provide improved rates of battery data updates. Shown in FIG. 3 and 4 are improved WiBaANs 300, 400 which are designed to shorten data acquisition time by including dual transceivers in the master nodes or M-BMUs. WiBaAN 300 include a plurality of sensor nodes or S-BMUs $302_{11}..302_{1m}, ... 302_{X1}..302_{Xn}$, a plurality of M-BMUs $304_1,...304_X$, and at least one top-level node or T-BMU 306. In FIG. 3, the M-BMUs $304_1...304_X$ contain RF transceivers $T_{11}..T_{X1}$ which facilitate wireless communications with S-BMUs $302_{11}..302_{1m}, ... 302_{X1}..302_{Xn}$. The M-BMUs $304_1...304_X$ also include RF transceivers $T_{12}..T_{X2}$ which facilitate wireless communication with the T-BMU 306. The dual wireless transceivers in each of the M-BMU $304_1...304_X$ advantageously allow each M-BMU to communicate with the S-BMUs while concurrently communicating with the T-BMU.

The WiBaAN in FIG. 4 is similar to the WiBaAN in FIG. 3 except that the M-BMU $404_1...404_X$ and T-BMU 406 communicate using a wired communication link. As such the M-BMU $404_1...404_X$ contain RF transceivers $T_{11},...T_{X1}$ for communications with the S-BMU $302_{11}..302_{1m}, ... 302_{X1}..302_{Xn}$, and include wired transceivers $T'_{12}, ...T'_{X2}$ to facilitate wired communications with the T-BMU 406. Such a configuration can be suitable in scenarios where the M-BMUs $404_1...404_X$ share a common electrical ground 408 with the T-BMU 406.

It should be noted that the exact communication protocols which are employed by the wireless and/or wired communications transceivers in FIGs. 3 and 4 are not critical to the solutions described herein. Any communication protocol can be used provided that it supports robust high speed data communications in a possibly noisy communication environment. As such the communications protocols can in some scenarios employ data various types of data compression and/or forward error correction.

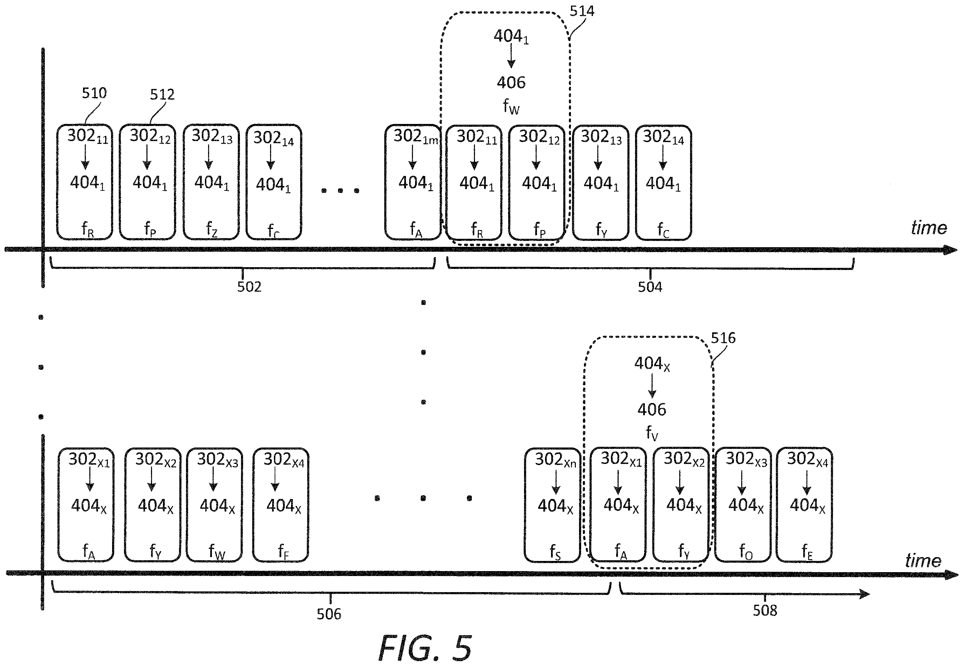

The dual transceiver configurations shown in FIGs. 3 and 4 can facilitate improved data throughput. This improvement can be understood with reference to FIG. 5 which shows a timing diagram for the WiBaAN in FIG. 4. A similar timing diagram would be facilitated with the configuration shown in FIG. 3.

In accordance with the timing diagram of FIG. 5, battery data is communicated from each S-BMU $302_{11}..302_{1m}$ to M-BMU $404_1$ during an S-BMU reporting cycle 502 associated with a battery module network $402_1$. For example, during a first time slot 510, data is communicated from S-BMU $302_{11}$ to M-BMU $404_1$. During a next time slot 512, data is communicated from S-BMU $302_{12}$ to the M-BMU $404_1$. This process continues until all of the S-BMU in a battery module network $402_1$ have completed their reporting. An S-BMU reporting cycle is completed when a plurality of S-BMU which are associated with a particular battery module network have each communicated their battery data to the M-BMU $404_1$. The battery data acquired by the M-BMU $404_1$ is communicated to the T-BMU 406 during the next reporting cycle 504 for the battery module network $402_1$, during a time slot 514. Since the M-BMU uses separate transceivers to communicate with the S-BMU and the M-BMU, the communications of the M-BMU with the S-BMUs can occur concurrently with communications between the M-BMU and the T-BMU.

Similarly, battery cell data is communicated from each S-BMU $302_{X1}..302_{Xn}$ to an M-BMU $404_X$ during a reporting cycle 506 of a battery module network $402_X$. This battery data is then communicated by the M-BMU $404_X$ to the T-BMU 406 during the next reporting cycle 508 associated with the battery module network, during a time slot 516. Since the M-BMU uses separate transceivers to communicate with the S-BMU and the M-BMU, the communications of the M-BMU with the S-BMU and the T-BMU can occur concurrently. In some scenarios, the transmissions between the T-BMU 406 and each of the M-BMU can be coordinated so that the reports from different M-BMU to the T-BMU do not overlap in time.

With the foregoing arrangement, communications between each M-BMU to the T-BMU can occur concurrently with M-BMU communications with the plurality S-BMU. For each battery module network, the data transmission from the M-BMUs to the T-BMU can occur during an S-BMU reporting cycle following the reporting cycle during which the M-BMU has acquired the battery cell data. As a result, the total data acquisition time is reduced to:

$$T_{DAT} = n * r * X * T.$$

where

$n$ = the total number of S-BMUs in a battery module network,
$r$ = the number of repeated data transmission between a S-BMU and a M-BMU,
$X$ = the number of M-BMUs in a particular WiBaAN, and
$T$ = unit data packet length (unit time slot length).

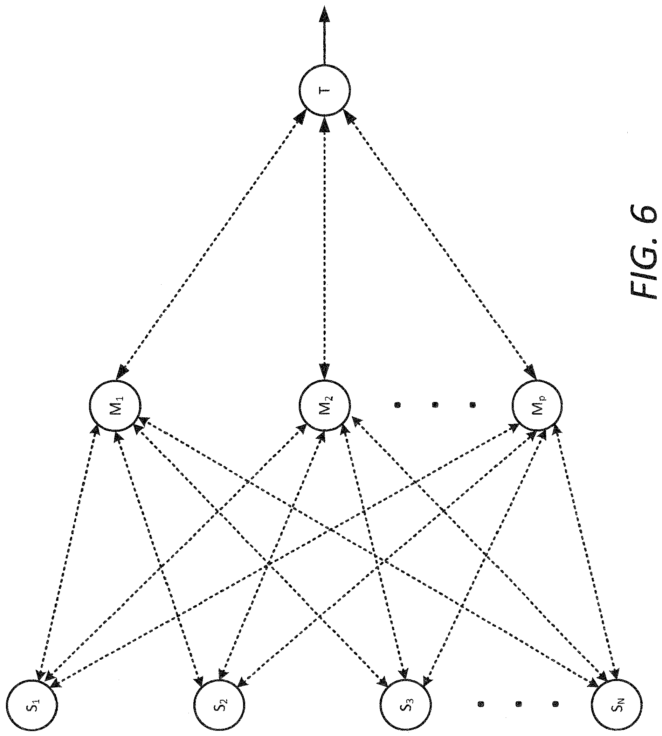

The data acquisition time of a WiBaAN can be further improved by combining the dual transceiver arrangement described in FIGs. 3 and 4, with an improved WiBaAN topology and communications protocol which will now be described with reference to FIGs. 6-9. In a conventional WiBaAN shown in FIG. 1, each wireless battery module network $102_1$.. $102_X$ is comprised of a plurality of S-BMUs, each communicating with a single M-BMU. One problem with this approach is that it can result in the inefficient use of the communication links which are available between the S-BMUs and the M-BMU. The reason for such inefficiency is that a transceiver in each S-BMU of a particular wireless battery module network $102_1$..$102_X$ will transmit its data to its assigned M-BMU, and will then enter a waiting state. For example, it can be observed in FIG. 1 that an S-BMU $104_{11}$ transmits its data to an M-BMU $106_1$ at time slot $202_{11}$ and then must wait while the remainder of the S-BMU $104_{12}$, $104_{13}$, ...$104_{1m}$ to transmit their data to the M-BMU $106_1$. The waiting state is necessary to allow the remainder of the S-BMUs in a particular wireless battery module network to transmit each of their battery data reports to the same M-BMU.

Accordingly, FIG. 6 illustrates a topology in which each S-BMU $S_1$, $S_2$, $S_3$ ... $S_N$ will communicate with a plurality of the M-BMU $M_1$, $M_2$, ... $M_p$. In the solution shown, each S-BMU $S_1$, $S_2$, ... $S_N$ will repeat the transmission of the same battery sensing data, by sending the same battery sensing data to each of the plurality of M-BMUs, so that the data is sent multiple times in different time slots or sub-time slots. In some respects, this approach is similar to the repeat transmissions of data illustrated in FIG. 2 with respect to time slot $202_{X1}$, where it is shown that the same data can be transmitted by an S-BMU (e.g., S-BMU $104_{X1}$) repeatedly using sub-time slots $202_{X1a}$, $202_{X1b}$, $202_{X1c}$. However, in the solution shown in FIG. 6, the repeated or redundant battery data transmission from a particular S-BMU which are sent during a plurality of time slots or sub-time slots, are communicated to a plurality of different M-BMUs $M_1$, $M_2$,...$M_p$ as opposed to being sent to just one M-BMU. Consequently, in some scenarios the number of M-BMUs in a particular BMS will correspond to the number of repeated transmission of the same sensory data.

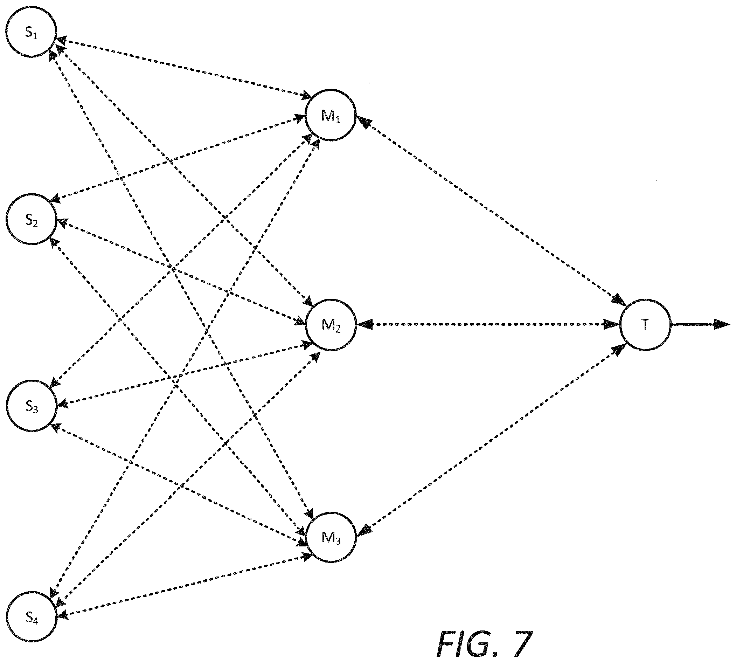

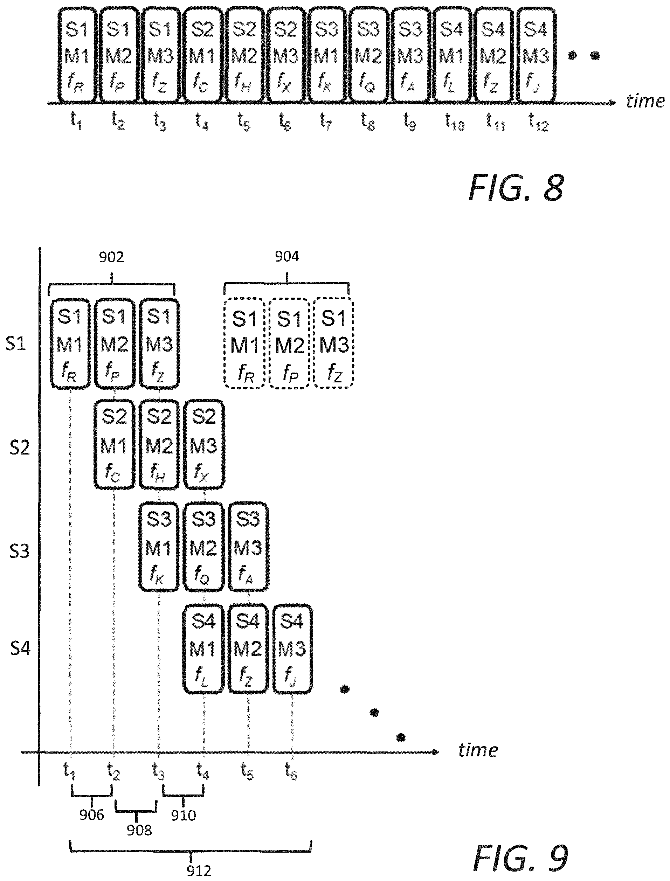

In order to appreciate the advantage of the generalized configuration shown in FIG. 6, it is useful to consider the simplified example shown in FIG. 7. In the example shown in FIG. 7, the WiBaAN consists of four S-BMUs $S_1$, $S_2$, $S_3$, $S_4$, three M-BMUs $M_1$, $M_2$, $M_3$, and one T-BMU (T). One example of a timing diagram of this network is shown in FIG. 8. The reporting scheme in FIG. 8 is similar in some respects to the method shown in FIG. 2, where each S-BMU transmits its data to the M-BMU, while the remaining S-BMU are essentially idle, waiting for their turn to transmit data. Here, it is shown that the first S-BMU (Si) transmits its sensing data to the first M-BMU ($M_1$) at $t_1$, transmits to the second M-BMU ($M_2$) at $t_2$, and transmits to the third M-BMU ($M_3$) at t3. The transmitters of the remainder of the S-BMU are essentially idle during this time. Thereafter, the second S-BMU ($S_2$) wirelessly transmits the battery sensing data to $M_1$, $M_2$, and $M_3$ at t4, t5, and t6, respectively. During this time, the transceivers of the remainder of the S-BMU are idle. This process continues as shown for the S-BMUs designated as $S_3$ and $S_4$. So in the transmission scheme that is shown in FIG. 8, the sensing data of each S-BMU is wirelessly transmitted to the three different M-BMUs, using one S-BMU at a time transmitting on different frequency channels.

In the scenario described with respect to FIGs. 7 and 8, the required data acquisition time is 12 time units. For example, if each time unit in FIG. 8 is a sub-time slot, and each transmission at $t_3$ - $t_{12}$ occurs during a sub-time slot, then 12 sub-time slots would be needed to complete the data acquisition from all four of the S-BMU $S_1$, $S_2$, $S_3$, $S_4$. However, the network configuration shown in FIG. 7 facilitate an improved data reporting which can be used to further reduce a data acquisition time.

Turning now to FIG. 9 it may be understood how pipelined data scheduling can be used to reduce acquisition time of sensed data. To facilitate this pipelined configuration, timing offsets 906, 908, 910 are used for communications from one or more of the S-BMU. For example, consider a scenario in which $S_1$ transmits data to M-BMUs $M_1$ - $M_3$ beginning at $t_1$ as shown in FIG. 9. $S_2$ transmits data to each of $M_1$ - $M_3$ beginning at t2, such that it has a timing offset or delay of 906. Accordingly, the transmissions from S-BMU $S_2$ to the M-BMUs $M_1$ - $M_3$ will always be delayed one time unit (e.g., a time slot or sub-time slot) relative to the transmissions of $S_1$. Sim-

ilarly, $S_3$ can transmit data to $M_1$ - $M_3$ in accordance with a two time unit delay relative to $S_1$.

The reporting cycle of each S-BMU will comprise a predetermined time period, and this reporting cycle of the S-BMU will repeat after the S-BMU has communicated its battery data to each of the M-BMUs. For example, a reporting cycle 902 of an S-BMU $S_1$ is shown in FIG. 9 as recurring at 904. It should be understood that a reporting cycle 902, 904 for each of the S-BMU $S_2$ - $S_4$ will repeat in a manner similar to that shown with $S_1$. However, the additional reporting cycles for $S_2$ - $S_4$ are omitted in FIG. 9 to facilitate greater clarity in understanding a system reporting cycle. It can be observed in FIG. 9 that the system reporting cycle 912 for the entire WiBaAN system shown in FIG. 7 is completed during time $t_1$ - $t_6$. Therefore, at a particular time slot, each of the various M-BMU $M_1$ - $M_3$ can be concurrently communicating with a different one of the S-BMU $S_1$ - $S_4$ using different frequency channels. This is best understood with reference to time slot t3 and t4 in FIG. 9 which shows that all of the M-BMUs $M_1$ - $M_3$ are concurrently active communicating with different ones of the S-BMUs $S_1$ - $S_4$.

Notably, with the timing configuration in FIG. 9 and strict frequency channel management, the required data acquisition time associated with a system reporting cycle 912 is reduced to 6 time units (e.g., where units can refer to time slots or sub-time slots). It may be noted that this duration of time represents a significant improvement as compared to the 12 units which are required to communicate the same battery cell data with the arrangement shown in FIG. 8. Further, by a dual transceiver configuration in the M-BMUs facilitates battery cell data transfer from M-BMUs ($M_1$ - $M_3$) to the T-BMU concurrently performed during the communications between the M-BMU and the S-BMU. As explained above, these communications with the T-BMU can be performed using wired or wireless communications for fast data acquisition time.

From the foregoing it will be understood that one or more the M-BMU $M_1$ - $M_3$ can be configured receive (during a battery management session) the battery cell data from each of the S-BMU $S_1$ - $S_4$ in a battery pack. Each of the M-BMU can be configured to communicate the battery cell data received from each of the S-BMU $S_1$ - $S_4$ in the battery pack to the one or more T-BMU. Consequently, the T-BMU will receive redundant battery cell data from the plurality of master nodes. According to one aspect, each of the M-BMU $M_1$ - $M_3$ can be configured to determine at least one of a state-of-charge (SoC) and a state-of-health (SoH) of the battery cells associated with each of the S-BMU. Each of the M-BMU $M_1$ - $M_3$ in such a scenario then can be further configured to communicate with the battery cell data, the SoC and/or SoH to the T-BMU. In other scenarios, each of the S-BMU $S_1$ - $S_4$ may be configured to determine the SoC and SoH of a battery cell to which it is connected. Such SoC and SoH data can then be communicated to an M-BMU, and ultimately to a T-BMU.

According to one aspect, a T-BMU is configured to use the battery cell data received from at least one of the M-BMUs $M_1$ - $M_3$ to calculate one or both of the SoC and the SoH of each battery cell. Note that this will be a redundant calculation in those scenarios where the SoC or SoH has already been calculated in an S-BMU or an M-BMU $M_1$ - $M_3$. In such a scenario, the T-BMU can be advantageously configured to compare at least one of the SoC and the SoH that has been calculated at the T-BMU, to an SoC or SoH which has been previously calculated in an M-BMU or an S-BMU for a corresponding battery cell. This process, whereby a comparison is performed with respect to the SoC or SoH values calculated for a particular battery cell at two different nodes, can facilitate system reliability. In particular, it provides a means to ensure that an SoC and/or SoH which has been calculated at the T-BMU is consistent with corresponding values calculated at the lower level nodes.

The WiBaAN described herein is flexible in terms of the number of components constituting each network and the link between constituent elements, so that it is easy to apply to any physical structure of the battery packs. A further advantage of the arrangement is that it is easily scalable. Further, it is relatively easy to configure network scheduling, network ID management and control of frequency hopping. From the foregoing it will be understood that the system is advantageous to use in a WiBaAN application that requires a very fast sensory data acquisition time.

The described features, advantages and characteristics disclosed herein may be combined in any suitable manner. One skilled in the relevant art will recognize, in light of the description herein, that the disclosed systems and/or methods can be practiced without one or more of the specific features. In other instances, additional features and advantages may be recognized in certain scenarios that may not be present in all instances.

As used in this document, the singular form "a", "an", and "the" include plural references unless the context clearly dictates otherwise. Unless defined otherwise, all technical and scientific terms used herein have the same meanings as commonly understood by one of ordinary skill in the art. As used in this document, the term "comprising" means "including, but not limited to".

Various aspects of sample embodiments according to the present disclosure may be appreciated, without limitation, from the following Enumerated Example Embodiments (EEEs) :

EEE 1: A battery management system for collecting data concerning battery cells in a battery pack comprising a multiplicity of battery cells, comprising: a plurality of sensor nodes, each configured to be connected to at least one corresponding battery cell of a battery pack, each sensor node including at least one sensor to facilitate measurement of a battery cell characteristic; one or more master nodes, each configured to communicate with the plurality of sensor nodes in at least a first communication session to request from the plurality of sensor nodes battery cell data representative of the battery cell characteristic, and to receive the battery cell data from the plurality of sensor nodes; at least one top level node configured to communicate with the one or more master nodes in at least a second communication session to receive the battery cell data from the one or more master nodes; wherein the one or more master nodes are each configured to conduct the first communication session concurrent with the second communications session.

EEE 2: The battery management system of EEE 1, wherein each of the one or more master nodes comprise a first data transceiver configured to facilitate the first communication sessions with the plurality of sensor nodes, and a second data transceiver different from the first data transceiver, that is configured to facilitate the second communication sessions.

EEE 3: The battery management system of EEE 2, wherein the first data transceiver is a wireless transceiver.

EEE 4: The battery management system of EEE 2 or EEE 3, wherein the second data transceiver is selected from the group consisting of a wired transceiver and a wireless communication transceiver.

EEE 5: The battery management system of EEE 4, wherein the one or more master nodes and the top level node share a common electrical ground, and the second data transceiver is a wired communication transceiver.

EEE 6: The battery management system of any of EEEs 2-5, wherein each of the plurality of sensor nodes is configured to redundantly communicate the battery cell data by resending identical battery cell data respectively to one of the master nodes during a plurality of predetermined time periods, each associated with a sensor node reporting cycle.

EEE 7: The battery management system of EEE 6, wherein a timing offset is assigned to one or more of the sensor nodes to cause the first communication session of each said sensor node with a particular one of the master nodes to be offset in time relative to the first communications sessions of others of the sensor nodes with the particular master node.

EEE 8: The battery management system of EEE 7, wherein the timing offset is selected to have a duration that is equal to at least one of the predetermined time period, and an integer multiple of the predetermined time period.

EEE 9: The battery management system of any of EEEs 2-8, wherein the one or more master nodes are configured to receive the battery cell data from each of the sensor nodes contained in the battery pack during a battery management session.

EEE 10: The battery management system of EEE 9, wherein each of the one or more master nodes is configured to communicate the battery cell data received from each of the plurality of sensor nodes to the at least one top level node.

EEE 11: The battery management system of EEE 10, wherein at least one set of nodes selected from the group consisting of each of the one or more master nodes and each of the plurality of sensor nodes is configured to use the battery cell data to determine at least one of a state-of-charge (SoC) and a state-of-health (SoH) of the battery cells associated with each of the sensor nodes.

EEE 12: The battery management system of EEE 11, wherein each of the one or more master nodes is configured to communicate to the at least one top level node the battery cell data from each of the plurality of sensor nodes, and at least one of the SoC and SoH for each of the battery cells.

EEE 13: The battery management system of EEE 12, wherein the at least one top level node is configured to use the battery cell data from at least one of the one or more master nodes to calculate one or both of the SoC and the SoH of each battery cell.

EEE 14: The battery management system of EEE 13, wherein the top level node is configured to compare at least one of the SoC and the SoH calculated at the top level node to a corresponding one of an SoC or SoH calculated in a lower level node selected from the group consisting of the master node and the sensor level node for a corresponding battery cell.

EEE 15: The battery management system of any of EEEs 1-14, wherein each of the plurality of sensor nodes is configured to determine at least one of a state-of-charge (SoC) and a state-of-health (SoH) of a battery cell to which it is connected.

EEE 16: A method of acquiring battery cell data from a multiplicity of battery cells in a battery pack, comprising: using a plurality of sensor nodes respectively connected to a plurality of battery cells of the battery pack to periodically determine battery cell data for each battery cell; periodically establishing a first communication session between each sensor node and each of one or more master nodes to receive in each of the one or more master nodes the battery cell data for each of the plurality of battery cells; periodically establishing a second communication session between at least one top level node and each of the one or more master nodes to obtain the battery cell data for each battery cell which has been received by the one or more master nodes; and minimizing a data acquisition time for the battery pack by configuring each of the one or more master nodes to perform the second communication sessions concurrent with the first communication sessions.

EEE 17: The method of EEE 16, further comprising using a first data transceiver of each of the one or more master nodes to facilitate each of the first communication sessions, and using a second data transceiver of each master node to concurrently facilitate each of the second communication sessions.

EEE 18: The method of EEE 17, further comprising using a wireless communication mode to facilitate each of the first communication sessions.

EEE 19: The method of EEE 17 or EEE 18, further comprising using a communication mode selected from the group consisting of a wired communication mode and a wireless communication mode to facilitate each of the second communication sessions.

EEE 20: The method of EEE 19, wherein the one or more master nodes and the top level node share a common electrical ground, and the method comprises using the wired communication mode to facilitate each of the second communication sessions.

EEE 21: The method of any of EEEs 17-20, further comprising redundantly communicating identical battery cell data from each of the plurality of sensor nodes, to each of the one or more master nodes during a plurality of predetermined time periods, each associated with a sensor node reporting cycle.

EEE 22: The method of EEE 21, further comprising applying a timing offset to one or more of the sensor nodes to cause each of the sensor nodes to communicate with each of the one of the master nodes at a different time.

EEE 23: The method of EEE 22, further comprising selecting the timing offset to have a duration that is equal to at least one of the predetermined time period, and an integer multiple of the predetermined time period.

Although the systems and methods have been illustrated and described with respect to one or more implementations, equivalent alterations and modifications will occur to others skilled in the art upon the reading and understanding of this specification and the annexed drawings. In addition, while a particular feature may have been disclosed with respect to only one of several implementations, such feature may be combined with one or more other features of the other implementations as may be desired and advantageous for any given or particular application. Thus, the breadth and scope of the disclosure herein should not be limited by any of the above descriptions. Rather, the scope of the invention should be defined in accordance with the following claims and their equivalents.

**Claims**

1. A battery management system for collecting data concerning battery cells in a battery pack comprising a multiplicity of battery cells, comprising:

   a plurality of sensor nodes, each configured to be connected to at least one corresponding battery cell of a battery pack, each sensor node including at least one sensor to facilitate measurement of a battery cell characteristic;
   one or more master nodes, each configured to communicate with the plurality of sensor nodes in at least a first communication session to request from the plurality of sensor nodes battery cell data representative of the battery cell characteristic, and to receive the battery cell data from the plurality of sensor nodes;
   at least one top level node configured to communicate with the one or more master nodes in at least a second communication session to receive the battery cell data from the one or more master nodes;
   wherein the one or more master nodes are each configured to conduct the first communication session concurrent with the second communications session.

2. The battery management system of claim 1, wherein each of the one or more master nodes comprise a first data transceiver configured to facilitate the first communication sessions with the plurality of sensor nodes, and a second data transceiver different from the first data transceiver, that is configured to facilitate the second communication sessions.

3. The battery management system of claim 2, wherein the first data transceiver is a wireless transceiver.

4. The battery management system of claim 2 or claim 3,
   wherein the second data transceiver is selected from the group consisting of a wired transceiver and a wireless communication transceiver; and
   wherein, in some embodiments, the one or more master nodes and the top level node share a common electrical ground, and the second data transceiver is a wired communication transceiver.

5. The battery management system of any of claims 2-4,
   wherein each of the plurality of sensor nodes is configured to redundantly communicate the battery cell data by resending identical battery cell data respectively to one of the master nodes during a plurality of predetermined time periods, each associated with a sensor node reporting cycle; and
   wherein, in some embodiments, a timing offset is assigned to one or more of the sensor nodes to cause the first communication session of each said sensor node with a particular one of the master nodes to be offset in time relative to the first communications sessions of others of the sensor nodes with the particular master node, wherein the timing offset is optionally selected to have a duration that is equal to at least one of the predetermined time period, and an integer multiple of the predetermined time period.

6. The battery management system of any of claims 2-5, wherein the one or more master nodes are configured to receive the battery cell data from each of the sensor nodes contained in the battery pack during a battery management session.

7. The battery management system of claim 6, wherein each of the one or more master nodes is configured to communicate the battery cell data received from each of the plurality of sensor nodes to the at least one top level node.

8. The battery management system of claim 7, wherein at least one set of nodes selected from the group consisting of each of the one or more master nodes and each of the plurality of sensor nodes is configured to use the battery cell data to determine at least one of a state-of-charge (SoC) and a state-of-health (SoH) of the battery cells associated with each of the sensor nodes.

9. The battery management system of claim 8,
   wherein each of the one or more master nodes is configured to communicate to the at least one top level node the battery cell data from each of the plurality of sensor nodes, and at least one of the SoC and SoH for each of the battery cells; and
   wherein, in some embodiments, the at least one top level node is configured to use the battery cell data from at least one of the one or more master nodes to calculate one or both of the SoC and the SoH of each battery cell, wherein the top level node is optionally configured to compare at least one of the SoC and the SoH calculated at the top level node to a corresponding one of an SoC or SoH calculated in a lower level node selected from the group consisting of the master node and the sensor level node for a corresponding battery cell.

10. The battery management system of any of claims 1-9, wherein each of the plurality of sensor nodes is configured to determine at least one of a state-of-charge (SoC) and a state-of-health (SoH) of a battery cell to which it is connected.

11. A method of acquiring battery cell data from a multiplicity of battery cells in a battery pack, comprising:

    using a plurality of sensor nodes respectively connected to a plurality of battery cells of the battery pack to periodically determine battery cell data for each battery cell;
    periodically establishing a first communication session between each sensor node and each of one or more master nodes to receive in each of the one or more master nodes the battery cell data for each of the plurality of battery cells;
    periodically establishing a second communication session between at least one top level node and each of the one or more master nodes to obtain the battery cell data for each battery cell which has been received by the one or more master nodes; and
    minimizing a data acquisition time for the battery pack by configuring each of the one or more master nodes to perform the second communication sessions concurrent with the first communication sessions.

12. The method of claim 11, further comprising using a first data transceiver of each of the one or more master nodes to facilitate each of the first communication sessions, and using a second data transceiver of each master node to concurrently facilitate each of the second communication sessions.

13. The method of claim 12, further comprising using a wireless communication mode to facilitate each of the first communication sessions.

14. The method of claim 12 or claim 13,
    further comprising using a communication mode selected from the group consisting of a wired communication mode and a wireless communication mode to facilitate each of the second communication sessions; and
    wherein, in some embodiments, the one or more master nodes and the top level node share a common electrical ground, and the method comprises using the wired communication mode to facilitate each of the second communication sessions.

15. The method of any of claims 12-14,
    further comprising redundantly communicating identical battery cell data from each of the plurality of sensor nodes, to each of the one or more master nodes during a plurality of predetermined time periods, each associated with a sensor node reporting cycle; and

in some embodiments further comprising applying a timing offset to one or more of the sensor nodes to cause each of the sensor nodes to communicate with each of the one of the master nodes at a different time, and optionally further comprising selecting the timing offset to have a duration that is equal to at least one of the predetermined time period, and an integer multiple of the predetermined time period.

FIG. 1
(Prior Art)

EP 3 731 535 A1

FIG. 2
(Prior Art)

FIG. 3

FIG. 4

*FIG. 5*

FIG. 6

FIG. 7

*FIG. 8*

*FIG. 9*

Europäisches
Patentamt

European
Patent Office

Office européen
des brevets

# EUROPEAN SEARCH REPORT

Application Number

EP 19 17 5499

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2015/028816 A1 (LEE INSEOP [US]) 29 January 2015 (2015-01-29) * paragraphs [0003] - [0010], [0063], [0066] * * claims 1,8,10; figures 4-6 * ----- | 1-15 | INV. H04Q9/00 |
| A | US 2014/035365 A1 (YOO HWAN-SUNG [KR]) 6 February 2014 (2014-02-06) * paragraphs [0005], [0011], [0044] - [0052] * * claims 1,6; figures 3,4,6 * ----- | 1-15 | |
| A | US 2014/145685 A1 (BOSCH ANDREAS [DE] ET AL) 29 May 2014 (2014-05-29) * column 4, line 30 - column 5, line 8 * * claims 1,5,10; figures 3,4 * ----- | 1-15 | |

TECHNICAL FIELDS
SEARCHED (IPC)

H04Q

The present search report has been drawn up for all claims

| Place of search | Date of completion of the search | Examiner |
|---|---|---|
| The Hague | 13 November 2019 | Gijsels, Willem |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

.........................................................................................
& : member of the same patent family, corresponding
document

EPO FORM 1503 03.82 (P04C01)

**ANNEX TO THE EUROPEAN SEARCH REPORT
ON EUROPEAN PATENT APPLICATION NO.**

EP 19 17 5499

This annex lists the patent family members relating to the patent documents cited in the above-mentioned European search report.
The members are as contained in the European Patent Office EDP file on
The European Patent Office is in no way liable for these particulars which are merely given for the purpose of information.

13-11-2019

| Patent document cited in search report | | Publication date | Patent family member(s) | | Publication date |
|---|---|---|---|---|---|
| US 2015028816 | A1 | 29-01-2015 | NONE | | |
| US 2014035365 | A1 | 06-02-2014 | CN | 103580090 A | 12-02-2014 |
| | | | KR | 20140019629 A | 17-02-2014 |
| | | | US | 2014035365 A1 | 06-02-2014 |
| US 2014145685 | A1 | 29-05-2014 | CN | 103250300 A | 14-08-2013 |
| | | | DE | 102010041049 A1 | 22-03-2012 |
| | | | EP | 2619844 A1 | 31-07-2013 |
| | | | US | 2014145685 A1 | 29-05-2014 |
| | | | WO | 2012038152 A1 | 29-03-2012 |

EPO FORM P0459

For more details about this annex : see Official Journal of the European Patent Office, No. 12/82

**EP 3 731 535 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 9293935 B